# EUROPEAN PATENT APPLICATION

(11) **EP 3 822 388 A1**
(43) Date of publication of application: **19.05.2021**
(21) Application number: 19774731.4
(22) Date of filing: 26.02.2019
(51) Int. Cl.: C23C 14/24, C23C 14/12, H05B 6/04

(54) **VAPOR DEPOSITION APPARATUS AND METHOD FOR PRODUCING ORGANIC ELECTRONIC DEVICE**

(30) Priority: 28.03.2018 JP 2018063368; 30.11.2018 JP 2018225361; 30.11.2018 JP 2018225362; 30.11.2018 JP 2018225363; 30.11.2018 JP 2018225364
(71) Applicant: Fukuoka Industry Science & Technology Foundation, Fukuoka-shi Fukuoka, 814-0001 (JP)
(72) Inventor: KOBAYASHI Shinichiro, Fukuoka-shi Fukuoka 814-0001 (JP); FUJIMOTO Hiroshi, Fukuoka-shi Fukuoka 811-0001 (JP); MIYAZAKI Hiroshi, Fukuoka-shi Fukuoka 814-0001 (JP)
(74) Representative: Cioncoloni, Giuliana
(86) International application number: PCT/JP2019/007301
(87) International publication number: WO 2019/187902

(57) **Abstract**

The purpose of the present invention is to provide: a practical vapor deposition apparatus which is suppressed in noise during the formation of a film of an organic material by means of induction heating; and the like. A vapor deposition apparatus for forming a film of an organic material on a substrate, which is provided with: a container, at least a part of which is configured from a conductor, and which contains the organic material; a coil which is arranged around the container; a power semiconductor which is connected to the coil; and a direct-current power supply which is connected to the power semiconductor. This vapor deposition apparatus is configured such that the power semiconductor functions as a transistor that constitutes a part of an inverter part which converts a direct current into an alternating current. By using a power semiconductor and a direct-current power supply, a large-sized alternating-current power supply becomes unnecessary. Consequently, it becomes easy for this vapor deposition apparatus to have a compact configuration.

## Description

### TECHNICAL FIELD

The present invention relates to a vapor deposition apparatus and an organic electronic device production method, and more particularly, to a vapor deposition apparatus or the like for forming an organic layer on a substrate from organic material.

### BACKGROUND ART

The present inventors have proposed a vapor deposition apparatus for forming an organic layer on a substrate from organic material based on induction heating (Patent Document 1). The induction heating system has advantage in thermal responsiveness as compared with the resistance heating system. As a result, heating and cooling are quickly performed, and precise temperature control can be performed.

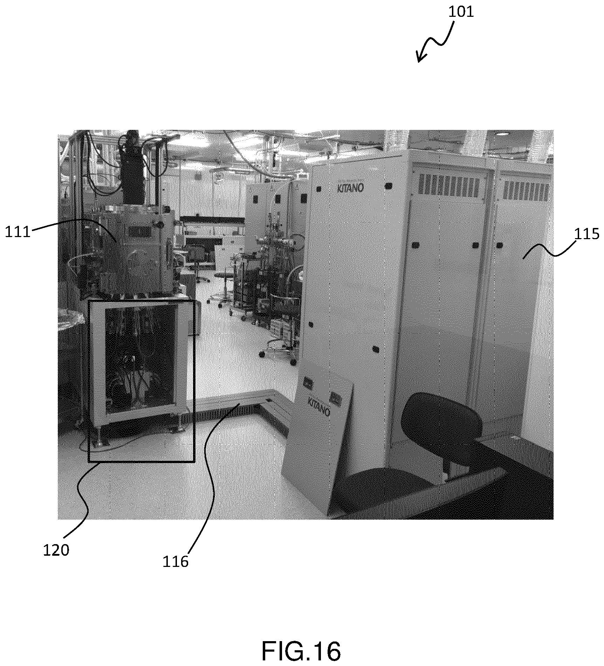

In general, a resistance heating system is adopted in a vapor deposition apparatus of an organic material. FIG. 16 is a schematic diagram of a vapor deposition apparatus based on resistance heating system. In FIG. 16, a resistance heating type vapor deposition apparatus (101) comprises at least a vacuum chamber (111), a power supply (115), and a cable (116). In FIG. 16, various cables and members are densely packed in a space (120) below the vacuum chamber (111), and there is no space for further housing a large-sized member.

### Prior Art Literature

### Patent Document

Patent Document 1: International Publication No. 2002/014575

### SUMMARY OF THE INVENTION

### PROBLEM SOLVED BY THE INVENTION

However, the power supply used for induction heating generally has a size of about 20 cm to 40 cm height, a 45 cm width, and a 60 cm depth. In addition, the weight is also large. As a result, it is difficult to store the large power supply used for induction heating under a vacuum chamber or somewhere around. Therefore, the large power supply used for induction heating and the vapor deposition chamber are arranged apart from each other. As a result, the parasitic capacitance increases between a plurality of power supply cables connected to a plurality of crucibles, which are containers for containing the organic materials.Therefore, the resonance frequency is deviated, and the power induced in the container 3 is lowered.. In addition, since the cable becomes long, the apparatus becomes more susceptible to the noise and the controllability of heating can be lowered. Also, the sensor system can be adversely affected due to noise.

Therefore, precise heating control becomes difficult. In the vapor deposition forming organic films, film thickness control at several nanometer levels and a plurality of materials mixing process with weight ratio control of 1% or less are required. So, it has been difficult to provide a practical vapor deposition apparatus for forming an organic layer from organic material based on an induction heating system.

The purpose of the present invention, therefore, is to provide a practical vapor deposition apparatus or the like to form organic layers based on induction heating system by suppressing noise while adopting an induction heating system which has advantage in thermal responsiveness.

### MEANS FOR SOLVING THE PROBLEM

A first aspect of the present invention is a vapor deposition apparatus for forming an organic layer on a substrate from organic material, comprising a container at least a part of which is composed of conductor and which stores the organic material; a coil disposed around the container; a power semiconductor connected to the coil; and a DC power supply connected to the power semiconductor, wherein the power semiconductor functions as a transistor constituting a part of an inverter unit that converts DC into AC.

A second aspect of the present invention is the vapor deposition apparatus according to the first aspect, further comprising a frequency control unit that controls a frequency of the AC output by the inverter unit.

A third aspect of the present invention is the vapor deposition apparatus of the second aspect, wherein the frequency control unit is a small oscillator device, and a distance between the coil and the small oscillator device is shorter than a distance between the small oscillator device and the DC power supply.

A fourth aspect of the present invention is the vapor deposition apparatus according to the third aspect, wherein the small oscillator device is a VCO or a DDS.

A fifth aspect of the present invention is the vapor deposition device of any of the first through the fourth aspects, comprising a plural of the power semiconductors, wherein among the power semiconductors, one of them is connected to high sides of both poles of the coil, respectively, and one of them is connected to low sides of both poles of the coil, respectively. More concretely, the vapor deposition device further comprises in the inverter unit: a first transistor provided on a high side of one pole of the coil; a second transistor provided on a low side of the one pole of the coil; a third transistor provided on a high side of the other pole of the coil; and a fourth transistor provided on a low side of the other pole of the coil.

The sixth aspect of the present invention is the vapor deposition apparatus according to the fifth aspect, wherein at least one of the first transistor, the second transistor, the third transistor and the fourth transistor is an IGBT, an Si power MOSFET, a GaN power FET or an SiC power MOSFET.

A seventh aspect of the present invention is the vapor deposition apparatus according to any one of the first through the sixth aspects, further comprising a capacitor connected in series with the coil, wherein the power semiconductor functions as a transistor constituting a part of an inverter unit that converts DC into AC; and wherein the capacitor is a metallized film capacitor or a large capacity power film capacitor.

An eighth aspect of the present invention is the vapor deposition device according to any one of the first through the seventh aspects, further comprising a plurality of capacitors connected in series with the coil, wherein the plurality of capacitors are arranged in parallel.

A ninth aspect of the present invention is the vapor deposition device according to any one of first through eighth aspects, wherein the plurality of power semiconductors are connected in parallel.

A tenth aspect of the present invention is the vapor deposition device according to any one of the first to the ninth aspects, further comprising a plurality of inverter units, wherein the plurality of inverter units are arranged in parallel.

An eleventh aspect of the present invention is the vapor deposition apparatus according to any one of the first through the tenth aspects, wherein a distance between the coil and the power semiconductor is shorter than a distance between the power semiconductor and the DC power supply.

A twelfth aspect of the present invention is the vapor deposition apparatus according to any one of the first through the eleventh aspects, further comprising a vacuum chamber disposed to enclose the container, wherein the coil is disposed outside the vacuum chamber.

A thirteenth aspect of the present invention is an organic electronic device production method, using a vapor deposition apparatus that forms an organic layer on a substrate from organic material, wherein the vapor deposition apparatus comprises: a container at least a part of which is composed of conductor and which stores the organic material; a coil disposed around the container; a power semiconductor connected to the coil; and a DC power supply connected to the power semiconductor; wherein the power semiconductor functions as a transistor constituting a part of an inverter unit that converts DC into AC, and wherein the organic electronic device production method includes: converting DC from the DC power supply into AC; and heating the container by flowing a current through the coil.

According to a fourteenth aspect of the present invention is the organic electronic device production method according to the thirteenth aspect, wherein the vapor deposition apparatus further comprises: an inverter unit connected to the coil; a DC power supply connected to the inverter unit; and a frequency control unit that controls a frequency of the AC output by the inverter unit, and wherein the organic electronic device production method includes: converting DC, with the inverter unit, from the DC power supply into AC; controlling, with the frequency control unit, a frequency of the AC; and heating the container by flowing the AC through the coil.

A fifteenth aspect of the present invention is the organic electronic device production method according to the fourteenth aspect, further including, after the heating, second controlling frequency with the frequency control unit.

A sixteenth aspect of the present invention is the organic electronic device production method according to any one of the thirteenth through the fifteenth aspects, wherein the vapor deposition apparatus comprises: an inverter unit connected to the coil; and a DC power supply connected to the inverter unit, wherein the inverter unit comprises: first transistor on a high side of one pole of the coil; a second transistor on a low side of the one pole of the coil; a third transistor on a high side of the other pole of the coil; and a fourth transistor on a low side of the other pole of the coil, wherein the organic electronic device production method includes: converting DC, with the inverter unit, from the DC power supply into AC; first heating in which the container is heated by flowing current from the one pole toward the other pole of the coil; and second heating in which the container is heated by flowing current from the other pole to the one pole of the coil.

### EFFECT OF THE INVENTION

According to each aspect of the present invention, by using a power semiconductor and a DC power supply, the influence of parasitic capacitance can be reduced even if the distance between the large power supply and the vapor deposition chamber is separated. In addition, the electric circuit in which AC current flows is shortened, and the risk of noise that adversely affects the sensor system such as a crystal oscillator can be reduced. Further, by using a power semiconductor which is much smaller than a DC power supply, the power semiconductor can be easily installed in a narrow space around the vapor deposition chamber.

Conventionally, even when a power semiconductor is used in a vapor deposition apparatus for inorganic material which is heated to several thousand degrees, it is not at least common that a power semiconductor is used for vapor deposition for organic material.

The present invention has been conceived of the usefulness of a power semiconductor on the basis of a novel technical idea that a practical vapor deposition apparatus can be supplied by reducing noise by using a DC power supply that cannot be originally used in an induction heating system.

According to the second aspect of the present invention, the heating control can be performed by controlling the frequency of the alternating current flowing through the coil. This makes it possible to perform non-linear control such as precision control and rapid control of the heating temperature of the crucible.

According to the third aspect of the present invention, the length of cables can be reduced. Therefore, it is easy to suppress the generation of parasitic capacitance and noise and their adverse effect on the circuit.

According to the fourth aspect of the present invention, since the switching frequency can be adjusted with voltage, the routing of cables and the number of devices can be reduced as compared with the case of using the function generator.

According to the fifth aspect of the present invention, voltage can be applied to the coil in different directions and current can be always made to flow to the coil.. As a result, the current can be used without waste, and the heating can be quickly performed. As a result, heat generation in each power semiconductor is suppressed, and the burden on circuit elements can be reduced.

According to the sixth or seventh aspect of the present invention, it is easy to reduce switching loss, suppress heat generation and element burden, and prevent accidents. In particular, the metallized film capacitor can flexibly change the value of the capacitor so that the resonance frequency becomes a high frequency such as 300 kHz or the like even if the structure such as the cross-sectional area or the number of turns of the coil is changed, and therefore, it is easy to suppress heat generation and element burden.

According to the eighth aspect of the present invention, the heat generation in the capacitor is suppressed, and the burden on circuit elements is easily reduced.. Normally, the capacitor is also modularized, and it is unlikely that the capacitors are arranged in parallel when there is no special intention. For a so-called person skilled in the art in the field of induction heating vapor deposition, this configuration could seem abnormal. But the present inventors have conceived of the present invention of this aspect on the basis of the idea that it is necessary to reduce the resistance component in order to suppress heat generation and that organic materials can be vapor-deposited even in the above arrangement.

According to the ninth aspect of the present invention, currents flowing in each power semiconductor are dispersed. Therefore, heat generation in the power semiconductor is suppressed, and the burden on the element is easily reduced.

According to the eleventh aspect of the present invention, by installing a power semiconductor and a circuit for controlling the power semiconductor near the coil for warming the container and converting the DC into AC, it is easy to reduce the influence of the parasitic capacitance generated between the plurality of power supply cables corresponding to the plurality of containers on the resonance frequency. In addition, since the electric circuit in which AC current flows is surely shortened, the reduction of noise which adversely affects the sensor system such as the crystal oscillator can be further facilitated.

According to the twelfth aspect of the present invention, since the organic material or the like does not adhere to the coil, it becomes easier to clean the vapor deposition apparatus, and the maintainability of the vapor deposition apparatus can be improved.

According to the fourteenth or fifteenth aspect of the present invention, in addition to the stable temperature control in the vicinity of the resonance frequency, the temperature can be rapidly controlled. Thus, for example, the measured value can be quickly returned to the set value (temperature or film-forming rate) when the measured value is largely changed from the set value in the feedback. In addition, the film forming rate can be rapidly changed due to dissolution of the organic material or the like. In such a case, it is possible to react quickly with the rapid control.

### BRIEF DESCRIPTION OF THE DRAWINGS

FIG. 1 is an end view of a part of the vapor deposition apparatus of the first embodiment;
FIG. 2 illustrates an electronic circuit of an induction heating system using a DC power supply and a MOSFET in the vapor deposition apparatus (1).
FIG. 3 is a picture of an example of a silicon power MOSFET.
FIG. 4 is a diagram showing a correlation between an applied voltage and a current of a DC power supply in a reduction model of the vapor deposition apparatus (1).
FIG. 5 is a graph showing the temporal change of temperature in the reduction model of the vapor deposition apparatus (1).
FIG. 6 is an end view of a part of the vapor deposition apparatus (41) of the second embodiment.
FIG. 7 is a diagram showing the temporal change of the temperature of the crucible and the picture of the vapor deposition apparatus.
FIG. 8 is a diagram showing a change in temperature and vapor deposition rate of a crucible containing an organic material.
FIG. 9 is a diagram showing device characteristics of an organic EL element manufactured by the vapor deposition apparatus of the present invention.
FIG. 10 is a diagram showing (a) the time dependency of the crucible temperature and (b) the response of the signal (frequency) of the film thickness meter when the voltage of the DC power supply is changed.
FIG. 11 is a diagram showing (a) the time dependency of the crucible temperature and (b) the response of the signal (frequency) of the film thickness meter when the switching frequency of the inverter is changed.
FIG. 12 is a diagram showing the relationship between the frequency of the alternating current flowing through the coil and the amount of charged energy.
FIG. 13 is a diagram showing a relationship between a frequency region and an input energy amount.
FIG. 14 is a circuit diagram showing an example in which power semiconductors are arranged in parallel.
FIG. 15 is a circuit diagram showing an example in which power semiconductors are arranged symmetrically.
FIG. 16 is a diagram showing an example of arrangement of a power supply and a vapor deposition chamber in a conventional vapor deposition apparatus (101).

### DETAILED DESCRIPTION

### FORM FOR CARRYING OUT THE INVENTION

### Example 1

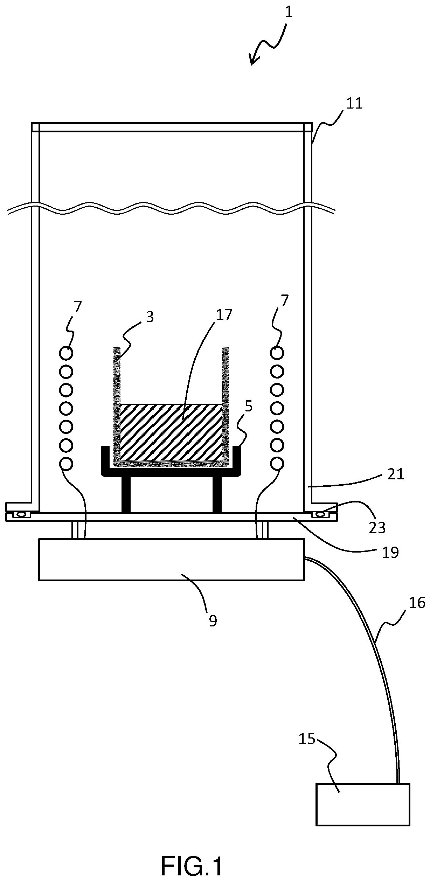

FIG. 1 shows an end view of a part of a vapor deposition apparatus 1 (an example of the "vapor deposition apparatus" in CLAIMS). The vapor deposition apparatus (1) comprises a container (3) (an example of a "container" in CLAIMS), a container holding unit (5), a coil (7) (an example of a "coil" in CLAIMS), a power semiconductor (9) (an example of a "power semiconductor" in CLAIMS), a vacuum chamber (11) (an example of a "vacuum chamber" in CLAIMS), a DC power supply (15) (an example of a "DC power supply" in CLAIMS), and a cable (16). The container (3) contains the organic material (17). The container holding unit (5) holds the container (3). The coil (7) is wound around the container (3). The power semiconductor (9) is electrically connected to the DC power supply (15) by a cable (16). The power semiconductor (9) is also connected to the coil (7). Further, the container (3), the container holding unit (5), and the coil (7) are inside the vacuum chamber (11). The power semiconductor (9), the DC power supply (15), and the cable (16) are outside the vacuum chamber (11)

At least a part of the container (3) is composed of a conductor. Specifically, a metallic container is coated with an insulating material. Therefore, when an AC current flows to the coil (7) arranged around the container (3), the conductor part of the container (3) is heated by induction heating. In addition, the container (3) and the coil (7) can be prevented from being electrically brought into contact with each other. The cooling efficiency is expected to be improved because the distance between the coil and the container (3) is very small when the coil can be cooled by the external cooling or by water flowing through a pipe. As a result, when the induction heating system is used, the thermal responsiveness is better and the temperature can be easily adjusted as compared with the resistance heating system.

The bottom surface (19) of the vacuum chamber (11) is removable for taking in and out the container 3. The bottom surface (19) and the side surface (21) of the vacuum chamber (11) are sealed by an O-ring (23). Therefore, the inside of the vacuum chamber (11) can be decompressed at a high degree of vacuum by a vacuum pump (not shown).. The vapor deposition apparatus (1) heats the container (3) under reduced pressure, thereby vaporizing the organic material (17) and forming the film on a substrate installed inside the vacuum chamber (not shown).

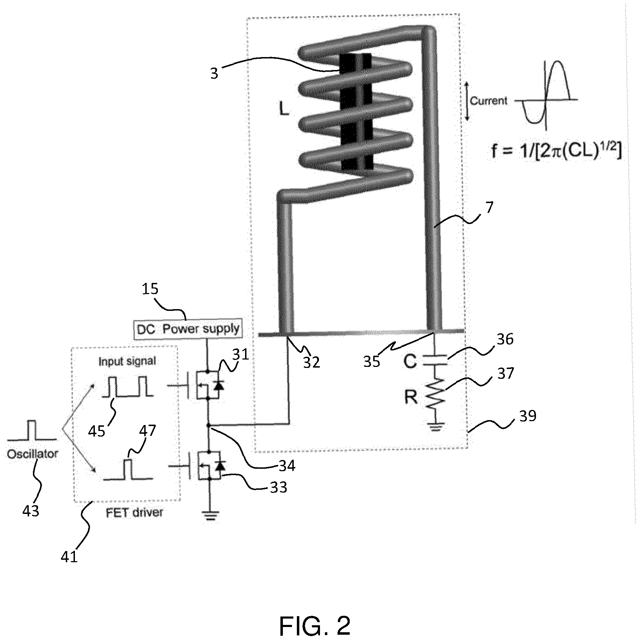

FIG. 2 is a diagram illustrating an electronic circuit of an induction heating system using a DC power supply and a MOSFET in the vapor deposition apparatus (1).

Referring to FIG. 2, a silicon power MOSFET (31) and a silicon power MOSFET (33) are connected in series in this order to a DC power supply (15). The silicon power MOSFET (33) is grounded on the opposite side from the silicon power MOSFET (31). The silicon power MOSFET (31) and the silicon power MOSFET (33) are connected in the reverse direction as viewed from the DC power supply (15), and the current from the DC power supply (15) does not flow through them in a state where there is no channel.

One end (32) of the coil (7) installed so as to wind around the container (3) is electrically connected to a contact (34) between the silicon power MOSFET (31) and the silicon power MOSFET (33). In addition, the other end (35) of the coil (7) is connected in series with a capacitor (36) and a resistor (37) in this order. The resistor 37 is grounded on the opposite side from the capacitor (36). The coil (7), the capacitor (36) and the resistor (37) form an RLC circuit section (39). The resistance (37) includes the internal resistance of the MOSFET and the resistance value of the wiring and the coil (7).

The FET drive circuit unit (41) is electrically connected to gate electrodes of the silicon power MOSFET (31) and the silicon power MOSFET (33), respectively. The FET drive circuit unit (41) receives a signal from the vibrator (43) and inputs an input signal (45) or an input signal (47) to a gate electrode of a silicon power MOSFET (31) or a silicon power MOSFET (33), respectively.

When the input signal (45) is inputted to the silicon power MOSFET (31) from the FET drive circuit unit (41), the silicon power MOSFET (31) is turned on. Then, a current flows in the direction from the DC power supply (15) through the silicon power MOSFET (31), the contact (34), the coil (7), the capacitor 36 and the resistor (37). When the input signal (47) is inputted to the silicon power MOSFET (33) from the FET driving circuit unit (41), the silicon power MOSFET (33) is turned on. Then, a current flows in the direction from the resistor (37) through the capacitor (36), the coil (7), the contact (34) and the silicon power MOSFET (33). By alternately inputting the input signal (45) and the input signal (47), the DC current from the DC power supply (15) can be converted into AC and supplied to the coil (7). That is, the silicon power MOSFET 33 functions as a transistor constituting a part of an inverter unit (an example of an inverter unit" in CLAIMS) for converting the DC current into AC.

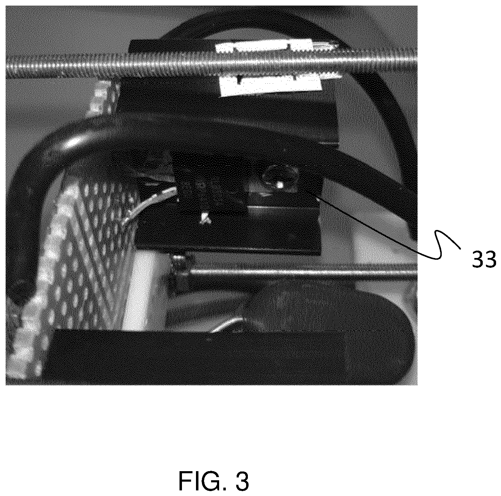

FIG. 3 shows a photograph of an example of a silicon power MOSFET. As shown in FIG. 3, the silicon power MOSFET is generally as small as a pen. Therefore, a space under a vacuum chamber in which the power supply is not stored can be installed. The oscillator and the DC power supply are connected to the drive circuit by a coaxial cable or a pair line. The oscillator can be miniaturized and installed next to the silicon power MOSFET or the driving circuit.

Thus, the vapor deposition apparatus 1 of this embodiment uses the power semiconductor 9 and the DC power supply 15 so as to reduce the influence of the parasitic capacitance even when the distance between the large power supply and the vapor deposition chamber is separated.. In addition, the electric circuit in which the AC current flows is shortened, and the reduction of noise which adversely affects the sensor system such as the crystal oscillator can be further facilitated.

The power semiconductor (9) is installed in a place close to the coil (7) as much as possible, and is installed in a place closer to the coil (7) than to the DC power supply (15).. The power semiconductor (9) functions as a transistor constituting a part of an inverter unit which is installed near the coil for heating the container (3) and converts DC into AC. Then, it is easier to reduce the influence of parasitic capacitance generated between the plurality of cables on the resonance frequency. In addition, since the circuit in which the AC current flows is certainly shortened, the noise affecting the sensor system such as the crystal oscillator is reduced.

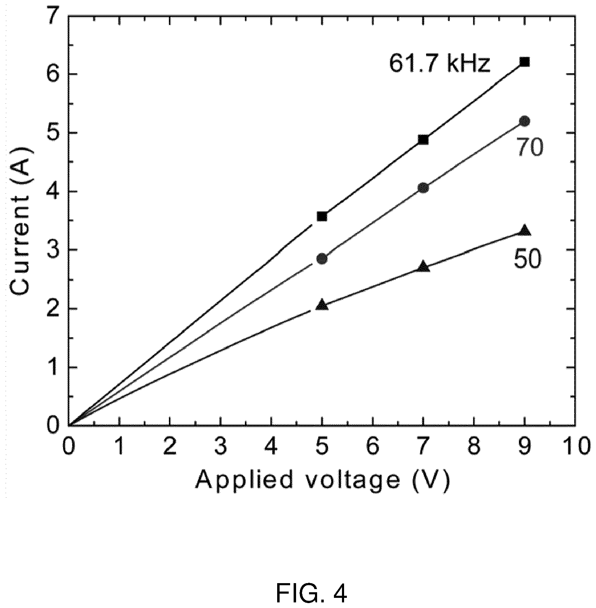

FIG. 4 is a diagram showing the correlation between applied voltage and current of the DC power supply in a reduction model of the vapor deposition apparatus (1) of the present embodiment. The horizontal axis indicates the value of the set voltage of the DC power supply 15. The vertical axis indicates value of the current supplied from the DC power supply. In this reduction model, the material of the coil is made of copper, the number of turns is 6, the length is about 50 mm, and the coil radius is about 10 mm.

As shown in FIG. 4, at the resonance frequency 61.7 kHz (square marker) in the RLC series resonance circuit adopted in this embodiment, the current flowing through the coil is increased in proportion to the applied voltage. When the resonance frequency is deviated from 61.7 kHz, the impedance becomes large, and the current is lowered. In FIG. 4, decrease in current is shown at 70 kHz (round marker) which is larger than the resonance frequency and at 50 kHz (triangular marker) which is smaller than the resonance frequency.Therefore, when the resonance frequency fluctuates frequently due to the influence of the parasitic capacitance, the frequency of the applied voltage is easily deviated from the resonance frequency. Then, the current flowing through the coil is also varied, and precise heating control of induction heating becomes difficult.

Since the parasitic capacitance is reduced in the vapor deposition apparatus (1), fluctuation of the resonance frequency of the RLC series resonance circuit is less likely to occur and reproducibility is improved. As a result, precise heating control by the induction heating system can be performed more than before.

In a vapor deposition apparatus for forming an organic layer based on organic material at a relatively low temperature, precise heating control is required as compared with the vapor deposition of the inorganic material. According to the vapor deposition apparatus of the present invention, which can reduce noise, it is possible to provide a vapor deposition apparatus capable of performing more precise heating control than a conventional vapor deposition apparatus.

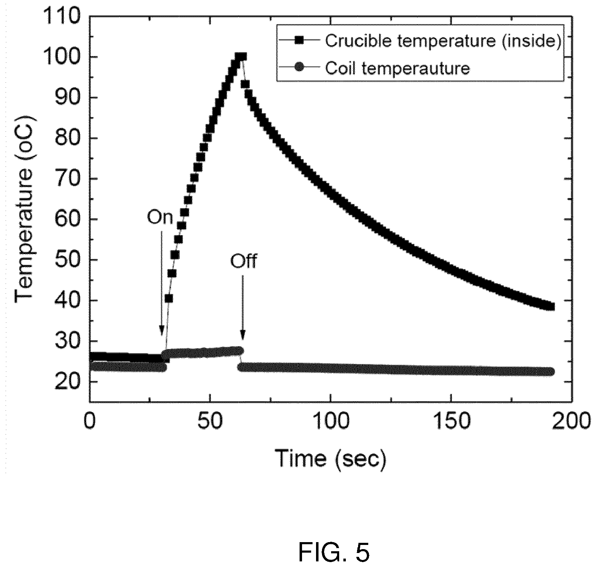

FIG. 5 is a graph showing the temporal change of the temperature in the reduction model of the vapor deposition apparatus (1). The horizontal axis indicates the elapsed time (seconds) and the vertical axis indicates the temperature (°C). The points plotted by the circles and squares indicate the temperatures of the coil and the crucible, respectively.

Referring to FIG. 5, it can be seen that the temperature in the crucible rises rapidly from about 25°C to about 100°C during about 30 seconds from the current flowing in the coil (the circuit being turned ON) to being turned off. It can be also seen that, after the current is turned off, the temperature in the crucible is rapidly cooled from about 100°C to about 45°C for about 100 seconds.

### Example 2

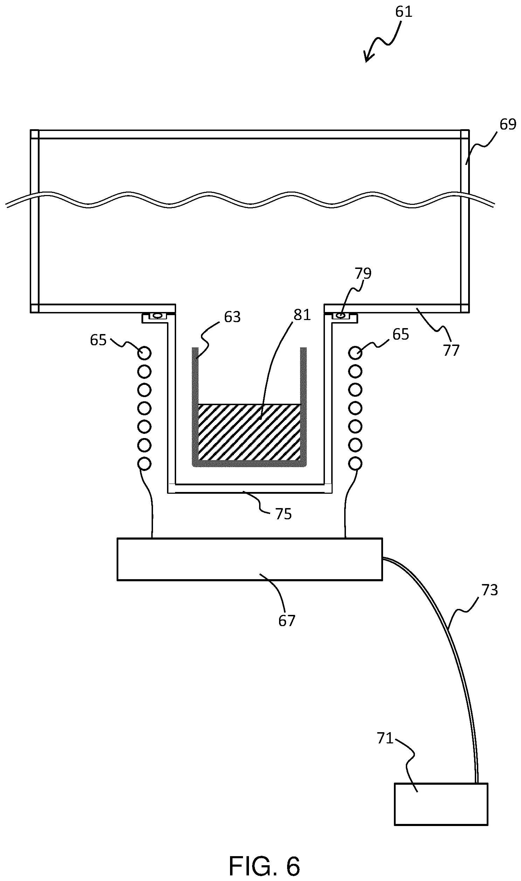

FIG. 6 shows an end view of a part of the vapor deposition apparatus (61) of the embodiment 2. The vapor deposition apparatus (61) comprises a container (63), a coil (65), a power semiconductor (67), a vacuum chamber (69), a DC power supply (71), and a cable (73). The main difference between the vapor deposition apparatus (61) and the vapor deposition apparatus (1) is that the coil (65) is disposed outside the vacuum chamber (69).

Specifically, the vacuum chamber (69) has a chamber bottom part (75) and a chamber upper part (77). The chamber bottom part (75) is connected to the chamber upper part (77) via the O-ring (79). The container (63) for storing the organic material (81) is disposed inside the chamber bottom part (75). The coil (65) is arranged so as to wind the container (63) from the outside of the chamber bottom part (75).

As shown in FIG. 6, the coil (65) and the container (63) are separated by a vacuum chamber (69), thereby preventing the organic material (81) from adhering to the coil (65). Conventionally, in order to wipe off the vapor deposition material adhering to the inside of the chamber, users wiped by hand work using organic solvents. In particular, time is required to wipe off a vapor deposition material adhering to a complicated structure such as a coil. The constitution of the example 2 facilitates cleaning and improves the maintainability of the vapor deposition apparatus (61).

Further, in a conventional resistance heating type vapor deposition apparatus, the container 63, the coil 65, and the power semiconductor 67 as an unit can replace the conventional resistance heating source, and the direct current power supply can be used as a vapor deposition apparatus of an induction heating system with high controllability.

The power semiconductors may not be silicon power MOSFETs, and may be, for example, SiC-MOSFETs, GaN power FETs, or IGBTs.

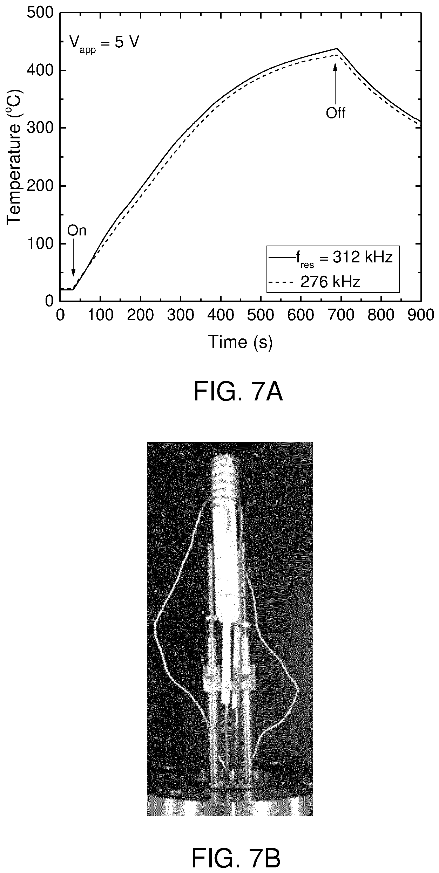

FIG. 7 is a diagram showing (a) the temporal change of the temperature of the crucible under vacuum and (b) a picture of the used vapor deposition apparatus. The horizontal axis of FIG. 7(a) is the elapsed time (sec), and the vertical axis is the temperature (°C) of the crucible. As shown in FIG. 7(a), in the vapor deposition apparatus of the present invention, the temperature of the crucible can be raised to 450°C for 10 minutes. Also, it is confirmed that the heating is possible even if the resonance point is changed.

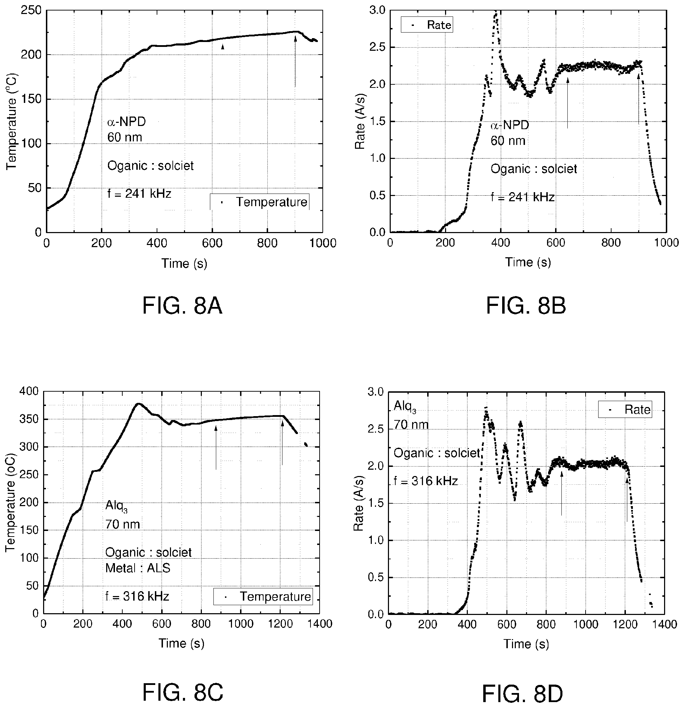

FIG. 8 is a diagram showing (a) the temporal change of the temperature of the crucible when D-NPD is put in the crucible, (b) a temporal change of the deposition rate of □-NPD, (c) the temporal change of the temperature of the crucible when Alq₃ is put in the crucible, and (d) the temporal change of the deposition rate of Alq₃. In general, D-NPD and Alq₃ are organic materials used as hole transport material and light emitting material, respectively. The resonance frequency is set to 241 kHz in the vapor deposition of D-NPD, and to 316 kHz in the vapor deposition of Alq₃.As shown in FIG. 8, it is confirmed that the crucible can be kept at a constant temperature after the lapse of a certain amount of time, and that the film can be formed at a constant deposition rate.

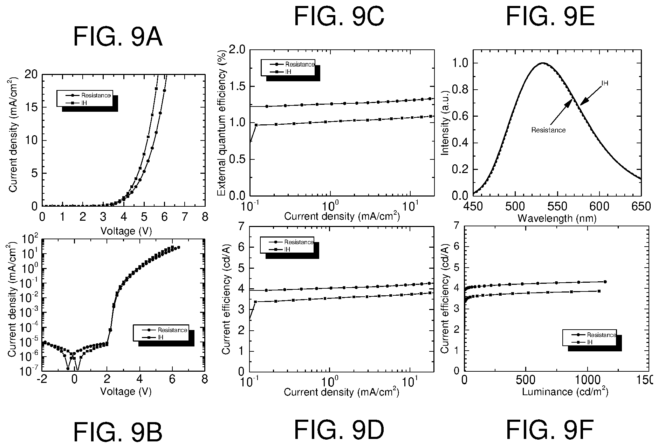

FIG. 9 is a diagram showing device characteristics of an organic EL device manufactured by using the vapor deposition apparatus of the present invention. The device structure is ITO (100 nm) / D-NPD (60 nm) /Alq₃ (70 nm) / LIF (1 nm)/Al (100 nm). The device characteristics of the organic EL device based on the induction heating system of the present invention are indicated by circular markers, and that based on conventional resistance heating system are indicated by diamond markers as a comparative example.

In FIG. 9 (a), the horizontal axis shows voltage (V), and the vertical axis shows current density (mA/cm²). FIG. 9 (b) is a diagram showing the vertical axis of FIG. 9 (a) logarithmically. In FIG. 9 (c), the horizontal axis shows current density (mA/cm²) and the vertical axis shows external quantum efficiency (%). In FIG. 9 (d), the horizontal axis shows current density (mA/cm²), vertical axis shows current efficiency (cd/A). In FIG. 9 (e), the horizontal axis shows the wavelength (nm) and the vertical axis shows the light intensity indicating the emission spectrum of the organic EL device. In FIG. 9 (f), the horizontal axis shows luminance (cd/m²), vertical axis shows current efficiency (cd/A).

As shown in FIG. 9, it is confirmed that an organic EL device having device characteristics equivalent to those manufactured based on a conventional resistance heating system can be manufactured with the vapor deposition apparatus of the present invention.

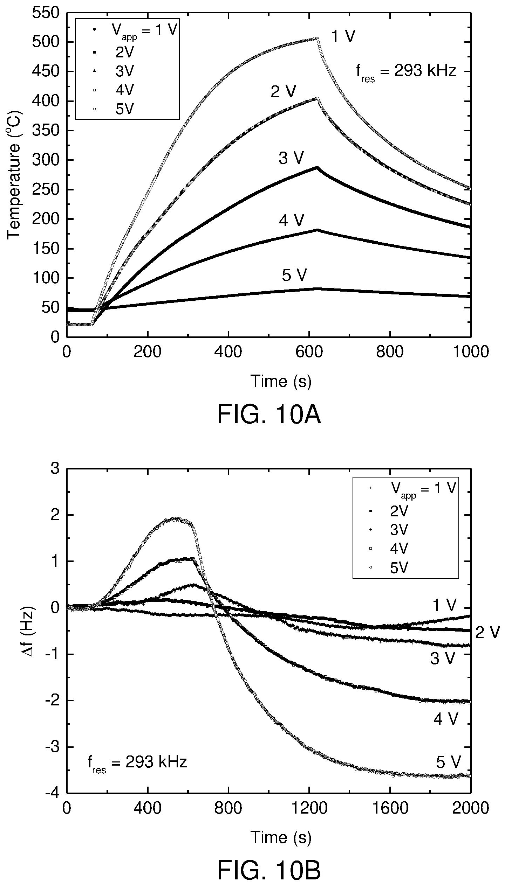

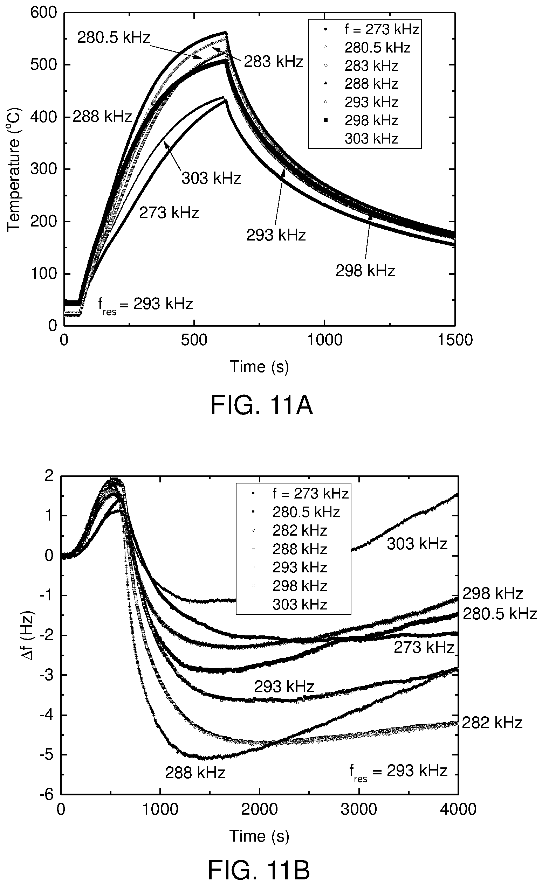

FIG. 10 and FIG. 11 are diagrams showing the influence of the vapor deposition apparatus of the present invention on a crystal oscillator (film thickness meter). FIG. 10 is a diagram showing (a) the time dependency of the crucible temperature and (b) the response of the signal (frequency) of the film thickness meter, when the voltage of the DC power supply is changed. FIG. 11 is a diagram showing (a) the time dependency of the crucible temperature and (b) the response of the signal (frequency) of the film thickness meter, when the switching frequency of the inverter is changed.

As shown in FIG. 10 (a), it can be seen that the temperature rising rate corresponds well with the change of the voltage. The temperature rising rate is linearly dependent on the voltage value and the current value. Also, according to FIG. 10 (b), even when the voltage of the DC power supply is changed, the frequency fluctuation of the film thickness meter is about 4 Hz or less. When the organic compound is deposited, the frequency of the film thickness meter is usually varied by about 500 to 1,000 Hz. Therefore, referring to FIG 10 (b), it has been found that the change in the voltage of the DC power supply does not cause a large fluctuation in film thickness measurement. When the voltage is large, the variation amount of the vibrator is large, but it is found that the variation is influenced by the radiation heat.

According to FIG. 11 (a), by changing the switching frequency of the inverter, the temperature rising rate and the maximum temperature vary. According to FIG. 11 (b), even if the switching frequency is changed, the frequency fluctuation of the film thickness meter is about 5 Hz or less. Therefore, it is also found that the change of the switching frequency of the inverter does not cause a large fluctuation in film thickness measurement.

Thus, it is confirmed that the vapor deposition apparatus of the present invention does not cause much noise on the film thickness meter so that the film thickness meter can normally measure the film thickness. In the above experiment, water flowing for air cooling is not utilized, and a curve shown in the figure is obtained by radiation heat during vapor deposition. Since water cooling can suppress the thermal influence on the film thickness meter, it is possible to more accurately measure the film thickness.

### Example 3

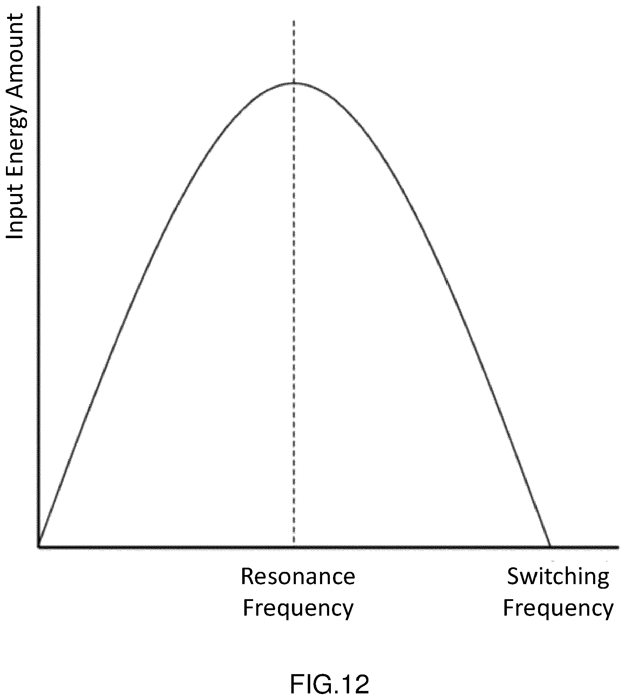

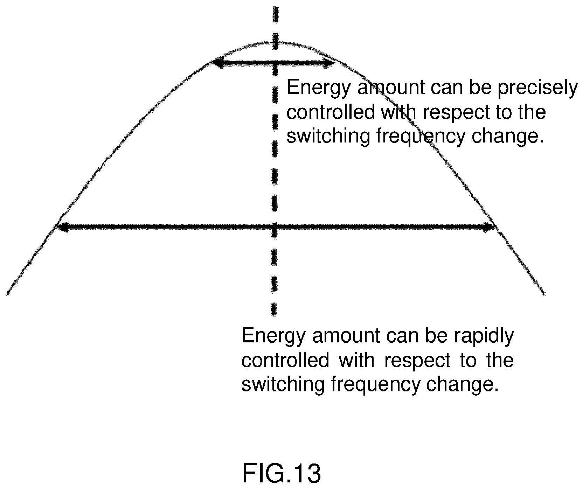

Next, with reference to FIGS. 12 and 13, heating control by frequency control is described in this embodiment. FIG. 12 is a diagram showing the relationship between the frequency of the alternating current flowing through the coil and the amount of charged energy. FIG. 13 is a diagram showing the relationship between the frequency region and the heating temperature.

As shown schematically in FIG. 12, by controlling the frequency using a frequency control unit such as a function generator, the maximum temperature is changed. This means that heating control can be performed by frequency control.

Further, although only linear control can be performed by conventional voltage and current control, non-linear control can be performed by frequency control. Specifically, as shown schematically in FIG. 13, in the frequency domain near the resonance frequency, only a little change is allowed in the maximum temperature with respect to the frequency change. Therefore, it is easy to precisely control the temperature. On the other hand, in a frequency region apart from the resonance frequency, the maximum temperature is largely changed with respect to the frequency change. Thus, the rapid control can be performed.

For example, by performing vapor deposition in the vicinity of the resonance frequency at forming the film, the heating temperature can be kept almost constant even for the variation of the frequency.. Therefore, the temperature can be precisely controlled in the vicinity of the resonance frequency, and the film can be stably formed. In addition, when the value (of temperature or film-forming rate) is larger than a value to be set while controlling, it is easy to return by largely changing the frequency.. The same operation can be realized by controlling a DC power supply, but the power supply which can output corresponding to the external signal is expensive. And it is supposed that many DC power supplies may not have such a function. Further, the design without requiring a special device other than the vapor deposition source can be easily incorporated into conventional vapor deposition apparatuses. Therefore, it is rather meaningful to provide the small-sized frequency control unit which can control the power.

Further, the structure of the frequency control unit included in the vapor deposition apparatus is described in detail below. In order to control the frequency of the AC flowing through the coil, a function generator having good frequency stability may be used as described above. However, it is much more functional than necessary for the organic electronic device production method using the vapor deposition apparatus of the present invention. Moreover, the function generator can cause the problem of the conventional vapor deposition apparatus because they are relatively large-sized devices so that the noise from the wiring and the cable should be generated.

Therefore, in this embodiment, a small oscillator device is used for miniaturization. A VCO (Voltage Controlled Oscillator) can be a choice for the small oscillator device. Since the switching frequency can be adjusted by voltage, it is possible to reduce cable wiring and devices as compared with the case of using the function generator.

As another small oscillator device, DDS (Direct Digital Synthesizer) may be used.. In this case, it becomes easier to control more stably by digital control.

By using a small oscillator device such as a VCO and a DDS, a control unit for frequency control as well as a control unit for AC generation can be stored in the lower part of the chamber, because the size of the control unit can be reduced.. In particular, in the same way as the power semiconductor, the small oscillator device can be installed in a place where the distance between the coil and the small oscillator device is shorter than the distance between the small oscillator device and the DC power supply, and preferably, the small oscillator device is installed in the lower part of the chamber, so that the cable length can be reduced. Therefore, it is easy to suppress the generation of parasitic capacitance and noise and the adverse effect on the circuit.

### Example 4

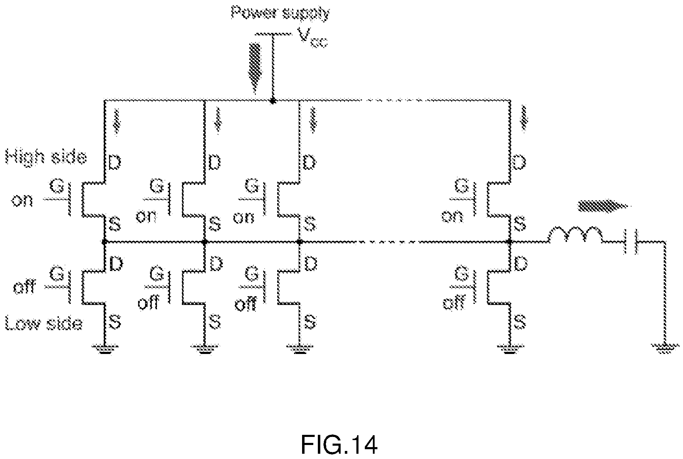

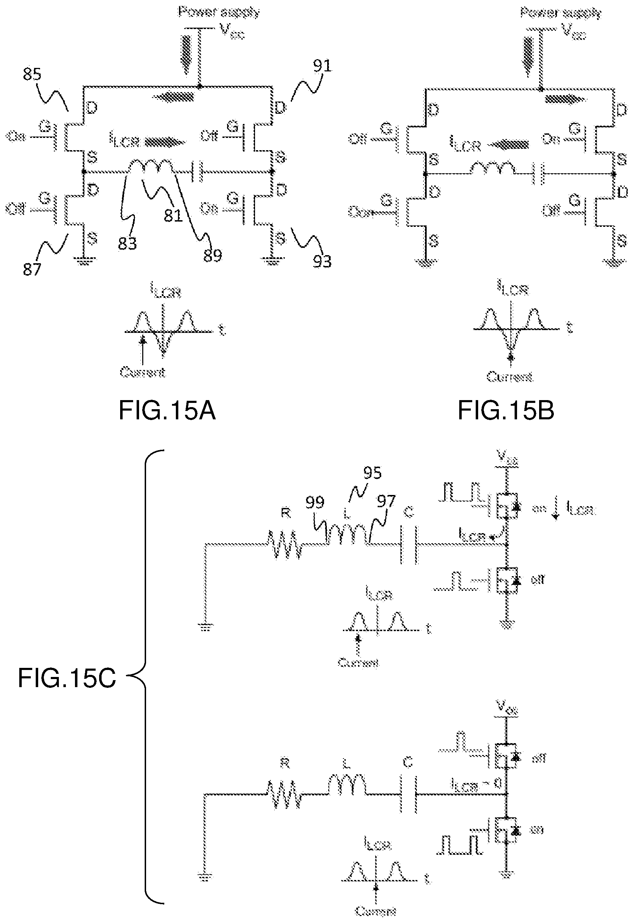

Next, with reference to FIGS. 14 and 15, a configuration for reducing a load on an element in a circuit used in the vapor deposition apparatus of the present invention will be described. FIG. 14 is a circuit diagram showing an example in which power semiconductors are arranged in parallel. FIG. 15 is a circuit diagram showing an example in which power semiconductors are arranged symmetrically

As shown in FIG. 14, by arranging power semiconductors functioning as inverter in parallel, currents flowing in each power semiconductor are dispersed. Therefore, heat generation in each power semiconductor is suppressed, and the burden on each element is easily reduced.

The same effect can be achieved by arranging the capacitors in parallel. In addition, a resistance component is present in the real capacitor, and even when AC flows at the resonance frequency, the capacitor is heated. By arranging the capacitors in parallel, the resistance components of the capacitors are reduced, and the heat generation of the capacitors can be suppressed.

In addition, an upper limit of current value to flow is set in the real capacitor. For example, it is likely that an upper limit value of a capacitor of 0.01 µF is 2A, and an upper limit value of a capacitor of 0.1 µF, which is 10 times larger, is only 4A.. In this case, it is possible to design a circuit which allows the current to flow up to 20A, which is 5 times larger than one capacitor of 0.1 µF, by arranging 10 capacitors of 0.01 µF in parallel.

Further, as shown in FIG. 15 (c), when two power semiconductors (transistors) are arranged only on one side of the coil, one on low side and one on high side, and voltage is applied, the current does not flow while the power semiconductor on the high side is off. Thus, as shown in 15 (a) and (b), the inverter unit of this embodiment has 4 transistors arranged symmetrically with respect to the coil (81). That is, the inverter unit has a first transistor (85) on the high side of one pole (83) of the coil (81), a second transistor (87) on the low side of the one pole (83) of the coil (81), a third transistor (91) on the high side of the other pole (89) of the coil (81), a fourth transistor (93) on the low side of the other pole (89) of the coil (81).In FIG. 15 (c), since a voltage Vcc is applied only in the direction from the one pole 97 toward the other pole 99 of the coil 95, there are time periods when no current flows. On the other hand, in the case of FIGS. 15 (a) and 15 (b), Vcc is applied to the coil 81 not only in the direction from one pole 83 toward the other pole 89 (Fig. 15 (a)), and Vcc is applied also in the direction from the other pole 89 toward the one pole 83 (Fig. 15 (b)). Thus, voltage can be applied to the coil 81 at all times by applying voltage to the both directions.As a result, the current can be used without waste, and the heating can be quickly performed.. As a result, heat generation in each power semiconductor is suppressed, and the burden on the element can be reduced.

Further, in order to flow a large current, load on circuit elements such as power semiconductors or capacitors are increased. When the power semiconductor is overheated and failed, no current is supplied to the coil. In a worse case, the power semiconductor can be subjected to thermal runaway and a large current flows into the FET driver. Then, the capacitor in the FET driver is ruptured and electric shock is likely to occur. This risk increases to provide a large vapor deposition apparatus or a sublimation apparatus which generally has a metallic cylindrical container with a larger diameter than that of a vapor deposition apparatus.

Therefore, an element having low ON resistance such as an IGBT, a GaN power FET or an SiC power MOSFET can be used for the power semiconductor, and a metallized film capacitor or a large capacity power film capacitor can be used for the capacitor. As a result, switching loss is reduced, heat generation and element burden are suppressed, and an accident can be prevented.

A magnetic material may be used for the material of the container 3 such as a crucible used in the vapor deposition apparatus or the sublimation generating apparatus, or a magnetic material may be mixed in the container 3. When a magnetic material is used in the container 3, when heated by induction heating, the magnetic material is magnetized, the magnetic field becomes easy to enter the container 3, the current flowing on the surface is effectively increased, and the heating efficiency is considered to be increased.

### DESCRIPTION OF THE REFERENCE NUMBERS

(1) vapor deposition apparatus, (3) container, (5) container holding unit, (7) coil, (9) power semiconductor, (11) vacuum chamber, (15) DC power supply, (16) cable, (17) organic material, (19) bottom surface of vacuum chamber, (21) side surface of vacuum chamber, (23) O-ring, (31) silicon power MOSFET, (33) silicon power MOSFET, (34) contact, (36) capacitor, (37) resistor, (39) RLC circuit unit, (41) FET drive circuit, (43) oscillator, (45) input signal, (47) input signal, (61) vapor deposition apparatus, (63) container, (65) coil, (67) power semiconductor: (69) vacuum chamber, (71) DC power supply, (73) cable; (75) chamber bottom part, (77) chamber upper part, (79) O-ring, (81) organic material, (101) vapor deposition apparatus, (111) vacuum chamber, (115) power supply, (116) cable, (120) space

## Claims

1. A vapor deposition apparatus for forming an organic layer on a substrate from organic material, comprising:
a container at least a part of which is composed of conductor and which stores the organic material;
a coil disposed around the container;
a power semiconductor connected to the coil; and
a DC power supply connected to the power semiconductor;
wherein the power semiconductor functions as a transistor constituting a part of an inverter unit that converts DC into AC.

2. The vapor deposition apparatus according to claim 1, further comprising a frequency control unit that controls a frequency of the AC output by the inverter unit.

3. The vapor deposition apparatus according to claim 2, wherein the frequency control unit is a small oscillator device, and a distance between the coil and the small oscillator device is shorter than a distance between the small oscillator device and the DC power supply.

4. The vapor deposition apparatus according to claim 3, wherein the small oscillator device is a VCO or a DDS.

5. The vapor deposition apparatus according to any one of claims 1 through 4, further comprising in the inverter unit:
a first transistor provided on a high side of one pole of the coil;
a second transistor provided on a low side of the one pole of the coil;
a third transistor provided on a high side of the other pole of the coil; and
a fourth transistor provided on a low side of the other pole of the coil.

6. The vapor deposition apparatus according to claim 5, wherein at least one of the first transistor, the second transistor, the third transistor and the fourth transistor is an IGBT, an Si power MOSFET, a GaN power FET or an SiC power MOSFET.

7. The vapor deposition apparatus according to any one of claims 1 through 6, further comprising a capacitor connected in series with the coil,
wherein the power semiconductor functions as a transistor constituting a part of an inverter unit that converts DC into AC; and
wherein the capacitor is a metallized film capacitor or a large capacity power film capacitor.

8. The vapor deposition apparatus according to any one of claims 1 through 7, further comprising a plurality of capacitors connected in series with the coil, wherein the plurality of capacitors are arranged in parallel.

9. The vapor deposition apparatus according to any one of claims 1 through 8, wherein the plurality of power semiconductors are connected in parallel.

10. The vapor deposition apparatus according to any one of claims 1 through 9, further comprising a plurality of inverter units, wherein the plurality of inverter units are arranged in parallel.

11. The vapor deposition apparatus according to any one of claims 1 through 10, wherein a distance between the coil and the power semiconductor is shorter than a distance between the power semiconductor and the DC power supply.

12. The vapor deposition apparatus according to any one of claims 1 through 11, further comprising a vacuum chamber disposed to enclose the container, wherein the coil is disposed outside the vacuum chamber.

13. An organic electronic device production method, using a vapor deposition apparatus that forms an organic layer on a substrate from organic material,
wherein the vapor deposition apparatus comprises:
a container at least a part of which is composed of conductor and which stores the organic material;
a coil disposed around the container;
a power semiconductor connected to the coil; and
a DC power supply connected to the power semiconductor;
wherein the power semiconductor functions as a transistor constituting a part of an inverter unit that converts DC into AC, and
wherein the organic electronic device production method includes:
converting DC from the DC power supply into AC; and
heating the container by flowing a current through the coil.

14. The organic electronic device production method according to claim 13, wherein the vapor deposition apparatus further comprises:
an inverter connected to the coil;
a DC power supply connected to the inverter; and
a frequency control unit that controls a frequency of the AC output by the inverter, and
wherein the the organic electronic device production method includes:
converting DC, with the inverter, from the DC power supply into AC;
controlling, with the frequency control unit, a frequency of the AC; and
heating the container by flowing the AC through the coil.

15. The organic electronic device production method according to claim 13 or 14, wherein the vapor deposition apparatus comprises:
an inverter unit connected to the coil; and
a DC power supply connected to the inverter unit,
wherein the inverter unit comprises:
a first transistor on a high side of one pole of the coil;
a second transistor on a low side of the one pole of the coil;
a third transistor on a high side of the other pole of the coil; and
a fourth transistor on a low side of the other pole of the coil,
wherein the organic electronic device production method includes:
converting DC, with the inverter unit, from the DC power supply into AC;
first heating in which the container is heated by flowing current from the one pole toward the other pole of the coil; and
second heating in which the container is heated by flowing current from the other pole to the one pole of the coil.
